## Europäisches Patentamt
## European Patent Office
## Office européen des brevets

(19)

(11) Numéro de publication: **0 019 560**
**B1**

(12) **FASCICULE DE BREVET EUROPEEN**

(45) Date de publication du fascicule du brevet:
06.10.82

(21) Numéro de dépôt: **80400702.9**

(22) Date de dépôt: **20.05.80**

(51) Int. Cl.³: **H 03 K 19/094,** H 01 L 27/08,
H 01 L 27/02, H 01 L 29/08

(54) Perfectionnements aux portes logiques à transistors MOS multidrains.

(30) Priorité: **21.05.79 FR 7912910**

(43) Date de publication de la demande:
**26.11.80 Bulletin 80/24**

(45) Mention de la délivrance du brevet:
**06.10.82 Bulletin 82/40**

(84) Etats contractants désignés:
**DE GB NL**

(56) Documents cités:
**DE-A 2 654 677**
**FR-A 2 358 025**

(73) Titulaire: **L'Etat Français représenté par le Secrétaire d'Etat aux Postes et Télécommunications, (Centre National d'Etudes des Telecommunications) 38-40 rue du Général Leclerc, F-92131 Issy-les-Moulineaux (FR)**

(72) Inventeur: **Majos, Jacques, 4, Rue Dauphine, F-22300 Lannion (FR)**
Inventeur: **Lardy, Jean-Louis, Lottissement Les Iris No 23 Le Versoud, F-38420 Domene (FR)**

(74) Mandataire: **Martinet, René et al, Cabinet Martinet 62, rue des Mathurins, F-75008 Paris (FR)**

BUNDESDRUCKEREI BERLIN

## Perfectionnements aux portes logiques à transistors MOS multidrains

La présente invention concerne des perfectionnements aux portes logiques qui sont relatives à un étage inverseur élémentaire et comprennent des transistors MOS multidrains. Plus particulièrement, elle a trait à une porte logique qui est constituée par un transistor inverseur multidrain à structure inégrée MOS monocanale du type à enrichissement et par un élément de charge ayant une zone de contact reliée à la zone du grille du transistor inverseur. La structure de la porte logique présente un premier niveau d'implantation sur la surface d'un substrat semi-conducteur d'un type de conductivité prédéterminé dans lequel sont implantées la zone de source unique et les zones de drain du transistor inverseur qui sont du type de conductivité opposée et séparées par la zone de canal unique du transistor inverseur, et un second niveau d'implantation constituant au moins la zone de grille en silicium polycristallin du transistor inverseur qui est superposée à ladite zone de canal par l'intermédiaire d'une couche isolante au-dessus du premier niveau d'implantation et qui est entourée complètement par la zone de source.

Une telle porte logique est décrite dans la demande de brevet français No. 2.411.512. Elle comporte, comme élément de charge, un transistor de charge à structure intégrée MOS monocanale du type à appauvrissement ou à enrichissement. La zone de source du transistor de charge est reliée à la zone de grille du transistor inverseur. Par ailleurs, dans une telle porte, la zone de grille entoure complètement les zones de drain du transistor inverseur, et, conjointement, une partie de la zone de canal du transistor inverseur est comprise entre les zones de drain voisines. Une telle structure exige une surface d'implantation relativement grande, notamment lorsqu'on désire utiliser une porte logique à faible consommation de courant. En effet, cette consommation étant proportionelle au rapport W/L où W et L sont respectivement les largeur et longueur d'un canal d'un transistor MOS, il apparaît que, pour un courant d'alimentation faible, la longueur L doit être grande et, par suite, la surface d'implantation notamment du transistor de charge est augmentée.

La présente invention a pour but de fournir des portes logiques à transistors MOS multidrains ayant une densité d'intégration plus grande que celle des portes logiques selon la demande de brevet français précitée No. 2.411.512.

A cette fin, une porte logique du type défini dans l'entrée en matière est caractérisée en ce qu'au moins une zone de drain du transistor inverseur est séparée d'une zone de drain voisine par une zone isolante s'étendant du premier niveau d'implantation jusqu'au moins au-delà du second niveau d'implantation.

L'insertion de zones isolantes entre les zones de drain voisines du transistor inverseur permet de supprimer la partie de canal intermédiaire entre les zones de drain et de diminuer la distance entre les zones de drain. En outre on peut prévoir le remplacement du transistor MOS de charge par une zone résistive de valeur ohmique élevée ce qui permet de réduire la surface d'implantation de l'élément de charge.

La combinaison des zones isolantes avec une zone de charge résistive ou la combinaison des zones isolantes et d'un transistor de charge conforme à la demande de brevet précitée, ou bien encore la combinaison des la zone résistive et d'un transistor inverseur conforme à la demande de brevet précitée confèrent des portes logiques ayant une densité d'intégration relativement importante.

D'autres avantages de la présente demande apparaîtront à la lecture de la description de plusieurs exemples de réalisation qui suit et à l'examen des dessins annexés correspondants, dans lesquels:

— la Fig. 1 représente le circuit symbolique d'une porte logique conforme à la demande de brevet français No. 2.411.512;

— la Fig. 2 est une vue en coupe suivant la ligne brisée II-II de la Fig. 3, montrant la structure d'une porte logique conforme à la demande de brevet français précitée, comportant un transistor inverseur MOS à trois drains et un transistor de charge;

— la Fig. 3 est une section détaillée, vue de dessus, de la porte logique représentée à la Fig. 2;

— la Fig. 4 est une section en vue da dessus simplifiée analogue à la Fig. 3, montrant les zones d'implantation principales d'un transistor inverseur à trois drains conforme à la demande de brevet français précitée;

— la Fig. 5 est une section en vue de dessus simplifiée montrant, comparativement à la Fig. 4, les zones isolantes d'un transistor inverseur à trois drains conforme à l'invention;

— la Fig. 6 est une vue en coupe suivant la ligne VI-VI de la Fig. 7 montrant la structure d'une porte logique conforme à l'invention, comportant un transistor MOS à trois drains;

— la Fig. 7 est une section détaillée, vue de dessus, de la porte logique représentée à la Fig. 6;

— la Fig. 8 représente le circuit symbolique d'une porte logique à élément de charge résistif;

— la Fig. 9 est une vue en coupe suivant la ligne IX-IX de la Fig. 10 montrant la structure d'une porte logique, comportant une zone résistive de charge; et

— la Fig. 10 est une section détaillée, vue de dessus, de la porte logique représentée à la Fig. 9.

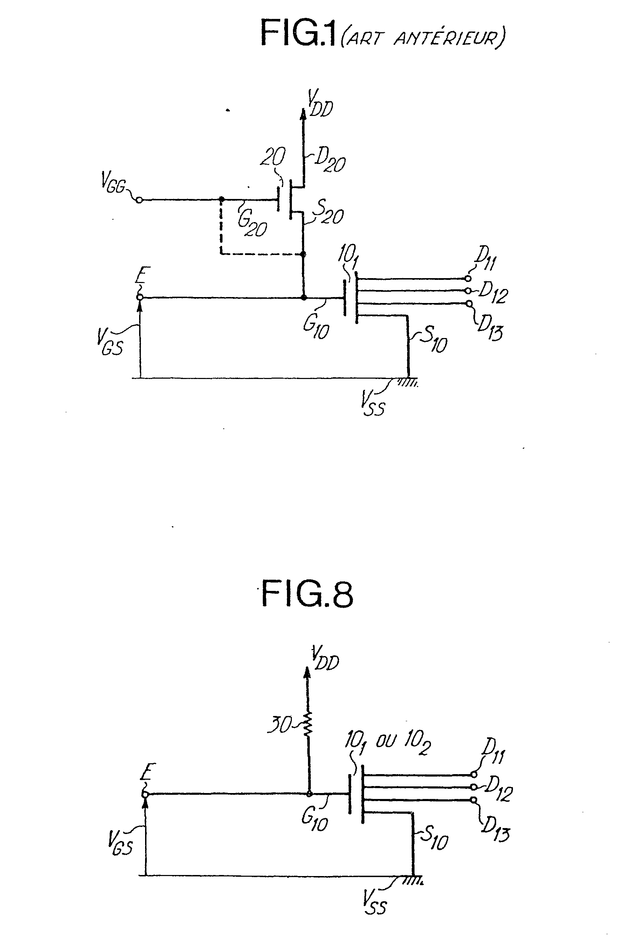

Avant de décrire les perfectionnements apportés par la présente invention, on rappellera, en référence aux Figs. 1 à 3, la structure d'une porte logique à transistor MOS multidrain selon la demande de brevet français No. 2.411.512.

Une telle porte logique, par exemple à trois drains de sortie, est représentée symboliquement à la Fig. 1. Elle est constituée par un transistor $10_1$, dit inverseur, qui commande les niveaux dessorties de la porte, et par un élément de charge, tel qu'un transistor de charge 20. Le transistor inverseur comporte trois drains de sortie $D_{11}$, $D_{12}$ et $D_{13}$, une grille unique $G_{10}$ et une source $S_{10}$ reliée au potentiel de référence $V_{SS}$. Le transistor de charge 20 joue le rôle d'un injecteur de courant pour les drains d'autres transistors multidrains (non représentés) qui ont leurs drains reliés à la grille $G_{10}$, par le fait qu'il alimente la grille $G_{10}$ du transistor inverseur $10_1$.

Le transistor inverseur $10_1$ est à structure MOS à enrichissement et à monocanal du type à conduction N. Le transistor de charge 20 est à structure MOS à monocanal du type à conduction N et peut être du type à appauvrissement ou à enrichissement. Le transistor de charge 20 a son drain $D_{20}$ relié à la borne positive $V_{DD}$ de la source de tension d'alimentation et a sa source $S_{20}$ reliée à l'entrée E des signaux de commande logiques qui sont appliqués sur la grille $G_{10}$ du transistor inverseur $10_1$. Lorsque le transistor de charge 20 est du type à appauvrissement — auquel on se référera dans la suite — la source $S_{20}$ est reliée à sa grille $G_{20}$, comme montré par al connexion en traits pointillés à la Fig. 1. Selon d'autres variantes, le transistor de charge peut être du type à enrichissement et/ou peut fonctionner en régime non-saturé pour lequel sa grille est polarisée à une tension convenable $V_{GG}$.

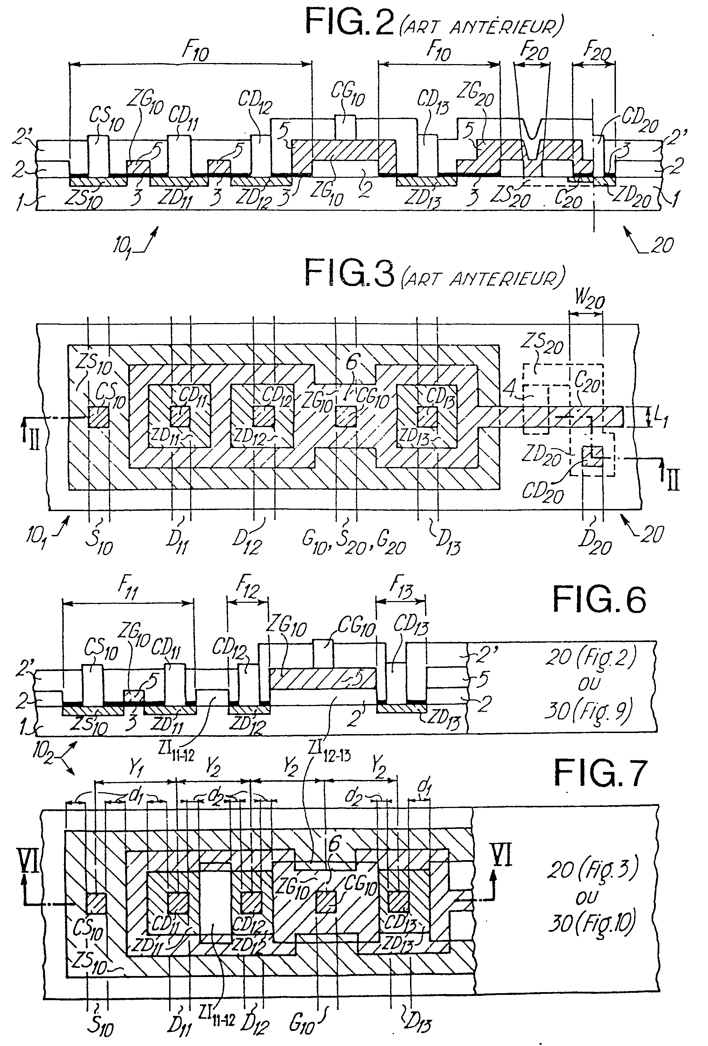

La fabrication d'une telle porte logique à transistors MOS à canal N et à grille en silicium polycristallin est réalisée par exemple selon la technologie Planar. Elle comporte les étapes suivantes en référence aux Figs. 2 et 3 (ou aux Figs. 2a à 2g de la demande de brevet français No. 2.411.512):

a) sur la surface d'un substrat 1 du type à conduction P qui définit un premier niveau d'implantation, on fait croître une couche isolante telle qu'une couche épaisse d'oxyde de silicium 2;

b) ouverture de fenêtre $F_{10}$ et $F_{20}$ correspondant aux sites d'implantation des transistors inverseurs $10_1$ et de charge 20 au moyen d'un premier masquage au cours duquel l'oxyde épais 2 est désoxydé complètement et substitué par oxydation à des couches isolantes minces 3 en oxyde de silicium d'environ 1000 Å dans lesdites fenêtres;

c) second et troisième masquages pour ajuster la tension de seuil du transistor de charge 20 par implantation ionique d'impuretés du type à conduction N à travers la couche d'oxyde mince 3 dans la zone du canal $C_{20}$ du transistor de charge à appauvrissement 20, et pour définir un premier plan d'interconnexions dans la fenêtre $F_{20}$ correspondant à la zone du précontact ohmique 4 qui relie les zones de grille et de source du transistor de charge 20 et qui est obtenue par désoxydation de l'oxyde mince 3 (voir la zone ombrée d'oxyde mince dans le transistor de charge représenté à la Fig. 3);

d) quatrième masquage pour déposer une couche de silicium polycristallin 5 d'environ 5000 Å définissant un second niveau d'implantation constituant les zones de grille $ZG_{10}$ et $ZG_{20}$ des transistors inverseur $10_1$ et de charge 20; on notera qu'au niveau du transistor de charge 20, le silicium polycristallin 5 est également déposé dans la zone 4 au voisinage de la zone de source $ZS_{20}$ afin de former le précontact entre les zones de grille et de source du transistor de charge 20;

e) diffusion d'impuretés du type à conduction N dans le substrat 1 à travers les couches d'oxyde minces 3 et au moyen du silicium polycristallin et de l'oxyde épais 2 servant de masque pour implanter sur le premier niveau d'implantation les zones de source $ZS_{10}$, de drain carrées $ZD_{11}$, $ZD_{12}$ et $ZD_{13}$ du transistor inverseur $10_1$ et les zones de source $ZS_{20}$ et de drain $ZD_{20}$ du transistor de charge 20; cette diffusion dope fortement le silicium polycristallin 5 sonstituant la zone de grille $ZG_{10}$, ce qui lui confère une faible résistivité; simultanément dans la zone de précontact 4, une faible quantité de l'élément dopant est diffusée à travers le silicium polycristallin 5 afin d'abaisser sa résistivité et, par suite, de réaliser le précontact ohmique 4;

f) dépôt par une seconde oxydation d'un oxyde de silicium épais 2' protégeant toutes les zones de la porte logique;

g) cinquième masquage et seconde désoxydation de l'oxyde de silicium épais 2' jusqu'aux zones de source $ZG_{10}$ et de drain $ZD_{11}$, $ZD_{12}$, $ZD_{13}$ et $ZD_{20}$ et jusqu'à la zone de grille $ZG_{10}$, pour délimiter des puits dans lesquels sont déposées des couches métalliques, par exemple en aluminium, réalisant les contacts $CS_{10}$, $CD_{11}$, $CD_{12}$, $CD_{13}$, $CD_{20}$ et $CG_{10}$ des zones précitées, le contact $CG_{10}$ étant celui de l'entrée de la porte logique et celui également des zones de source et de grille du transistor de charge à appauvrissement 20;

simultanément au dépôt de la couche métallique, sont réalisées les électrodes des sources, drains et grilles des transistors, représentées en traits fins sur la Fig. 3 ou, plus généralement, lursque la porte logique est incluse dans un circuit intégré complexe, sont réalisées les liaisons métalliques entre différentes portes logiques.

Selon l'exemple de réalisation montré aux Figs. 2 et 3 — auquel on se réfère dans la suite à titre de comparaison avec les structures de porte conformes à l'invention — on a supposé qu'un passage pour une liaison d'interconnexion était superposé à la zone de grille $ZG_{10}$ du transistor inverseur $10_1$ entre les zones de drain $ZD_{12}$ et $ZD_{13}$, ce qui est illustré par l'étranglement 6, et également que la zone de drain $ZD_{20}$ du transistor de charge 20 — représentée en dessous du canal $C_{20}$ sur la Fig. 3 — n'était pas alignée avec les autres zones de drain afin de réduire la surface d'implantation de la porte logique. D'autre part, en référence à la Fig. 3, on remarquera que la zone de source $ZS_{20}$ du transistor de charge 20 est coudée de manière à réaliser, d'un côté son contact avec la zone de grille $ZG_{20}$ (ou $ZG_{10}$) dans la zone 4 et de l'autre côté sa jonction avec le canal $C_{20}$ de largeur $W_{20}$ et de longueur $L_1$.

De manière générale, le transistor inverseur $10_1$ à trois drains $D_{11}$, $D_{12}$ et $D_{13}$ a la structure représentée schématiquement en vue de dessus à la Fig. 4. On voit que le canal $C_{10}$ du transistor inverseur $10_1$ sur le premier niveau d'implantation est superposable horizontalement à la zone de grille $ZG_{10}$ sur le second niveau d'implantation et entoure complètement les trois zones de drain $ZD_{11}$, $ZD_{12}$ et $ZD_{13}$. Ainsi, la grille $ZG_{10}$ présente des »trous« à section carrée $c \times c$ à la base desquels sont implantées sur le premier niveau d'implantation les zones de drain $ZD_{11}$, $ZD_{12}$ et $ZD_{13}$. Ces implantations permettent de définir trois transistors inverseurs MOS élémentaires »drain-source« 11, 12 et 13 qui sont constitués chacun par une zone de drain $ZD_{11}$, $ZD_{12}$, $ZD_{13}$ et par la zone de source $ZS_{10}$ définissant entre elles un canal élémentaire $C_{11}$, $C_{12}$, $C_{13}$ et également de définir deux transistors de liaison »drain-drain« 11 — 12 et 12 — 13 qui sont constitués chacun par une zone de drain $ZD_{11}$, $ZD_{12}$ et par une zone de »source« $ZD_{12}$, $ZD_{13}$ définissant entre elles un canal de liaison $C_{11-12}$, $C_{12-13}$. Tous les canaux élémentaires et de liaison ont une même longueur $L_1$ qui est égale au minimum imposé par la technologie die fabrication adoptée. Leurs largeurs sont différentes et dépendent de leurs emplacements dans la structure. Ainsi, la largeur des canaux $C_{11}$, $C_{13}$ des transistors élémentaires extrêmes 11, 13 est approximativement égale à 3c, celle du canal d'un transistor élémentaire central, tel que $C_{12}$, à 2c, et celles des canaux des transistors de liaison, tels que 11 — 12 et 12 — 13, à c.

En se référant maintenant à la Fig. 5, on a représenté, d'une manière analogue à la Fig. 4, un transistor inverseur MOS à trois drains $10_2$ conforme à l'invention. On voit que la structure de ce transistor $10_2$ diffère de celle de $10_1$ par le remplacement des zones de grille $ZG_{10}$ qui sont comprises entre deux zones de drain voisines $ZD_{11}$ et $ZD_{12}$ ou $ZD_{12}$ et $ZD_{13}$ par deux zones d'isolation $ZI_{11-12}$ et $ZI_{12-13}$. Ces zones d'isolation créent une véritable isolation électrique entre les zones de drain et sont en oxyde de silicium épais.

La fabrication du transistor inverseur $10_2$ est sensiblement analogue à celle décrite précédemment pour le transistor inverseur $10_1$ conforme à la demande de brevet français No. 2.411 512, aux différences près suivantes montrées aux Figs. 6 et 7:

— lors du premier masquage à l'étape b, on procède, comme montré à la Fig. 6, aux ouvertures de fenêtres $F_{11}$, $F_{12}$ et $F_{13}$ correspondant uniquement aux sites d'implantation des transistors MOS élémentaires 11, 12 et 13, de sorte que les »canaux de liaison« $C_{11-12}$ et $C_{12-13}$ définis précédemment restent recouverts par de l'oxyde épais 2 formant les zones isolantes $ZI_{11-12}$ et $ZI_{12-13}$; et

— lors du quatrième masquage à l'étape d, la couche de silicium de polycristallin formant la zone de grille $ZG_{10}$ peut recouvrir une faible partie d'une zone isolante, telle que $ZI_{11-12}$, ou la majeure partie, voire la totalité, d'une zone isolante telle que $ZI_{12-13}$, comme montré à la Fig. 7.

Ainsi, les transistors de liaison 11 — 12 et 12 — 13 du transistor inverseur $10_1$ sont supprimés dans le transistor inverseur $10_2$ conforme à l'invention et, au niveau des zones isolantes $ZI_{11-12}$ et $ZI_{12-13}$, selon leur hauteur montrée à la Fig. 6, il y a absence au moins des premier et second niveaux d'implantation. En effet, comme cela apparaît dans la Fig. 6, les zones isolantes ZI peuvent s'éten dre au-delà des zones de source et de drain dans le substrat 1, c'est-à-dire en dessous du premier niveau d'implantation et également au-delà de la zone de grille effective, qui interagit directement avec les zones de drain et de source, c'est-à-dire au-dessus du second niveau d'implantation.

Les zones isolantes ZI du transistor $10_2$ ont, de préférence, une longueur $L_2$ plus faible que celle $L_1$ des canaux de liaison du transistor inverseur $10_1$, afin de réduire le pas Y du réseau d'implantation correspondant à la distance entre deux sites de contact de drains voisins qui sont implantés en des noeuds dudit réseau et, par suite, afin d'augmenter la densité d'intégration. Ainsi, en se référant aux Figs. 4 et 5, si $L_1$ est la longueur des canaux des transistors élémentaires des transistors inverseurs $10_1$ et $10_2$ ainsi que celle des transistors de liaison 11 — 12, 12 — 13 du transistor inverseur $10_1$, on a l'inégalité suivante:

$$L_2 \leq L_1$$
et/ou l'inégalité suivante:
$$d_2 \leq d_1$$

où $d_1$ est la distance entre la zone de contact ZC, ayant une section carrée $c' \times c'$ dans une zone de drain rectangulaire ZD, et la zone de grille $ZG_{10}$, et où $d_2$ est la distance entre la zone de contact ZC d'une zone de drain ZD et une zone isolante voisine ZI. On peut choisir en practique les relations suivantes données à titre d'exemple:

$$d_1 \simeq 2\, d_2$$
$$\text{Pas } Y_1 \text{ (Fig. 4)} \simeq 1,25 \times \text{Pas } Y_2 \text{ (Fig. 5)}$$
$$C' + 2\, D_1 \simeq 1,7 \times (c' + 2\, D_2)$$

On notera que l'augmentation relative de la densité d'intégration d'une porte logique conforme à la présente invention, relativement à une porte logique conforme à la demande de brevet précitée, se fait au détriment de la largeur W des canaux des transistors élémentaires 11, 12 et 13. Par suite, le courant maximum admissible par la porte logique est plus faible (inférieur à $\simeq 120\,\mu A$ au lieu de $\simeq 200\,\mu A$) ainsi que sa rapidité de commutation pour des capacités de sortie élevées. On notera à cet égard que, pour des capacités de sortie faibles, la rapidité de commutation est améliorée, pour un courant prédéterminé, du fait que la surface de la grille $ZG_{10}$ du transistor $10_2$ et, corollairement, la capacité grille sont diminuées.

En se référant maintenant aux Figs. 8 à 10, on a représenté une porte logique MOS à transistor inverseur multidrain qui comporte un élément de charge uniquement résistif 30. Cet élément 30 est une résistance de valeur ohmique élevée dont une borne est reliée à la grille $G_{10}$ du transistor inverseur $10_2$ (ou $10_1$) et dont l'autre borne est reliée à la borne positive $V_{DD}$ de la source d'alimentation, comme montré à la Fig. 8.

La résistance 30 peut être réalisée en silicium polycristallin conjointement à la zone de grille $ZG_{10}$ du transistor inverseur. La fabrication de la porte logique, comparativement à celle selon la demande de brevet français No. 2.411.512, est plus simple puisqu'elle ne comporte plus les différentes étapes nécessaires à l'implantation du transistor de charge 20. En outre, la porte logique a une surface d'implantation réduite, par le fait que la zone résistive 30 est plus petite que la zone d'implantation du transistor de charge 20.

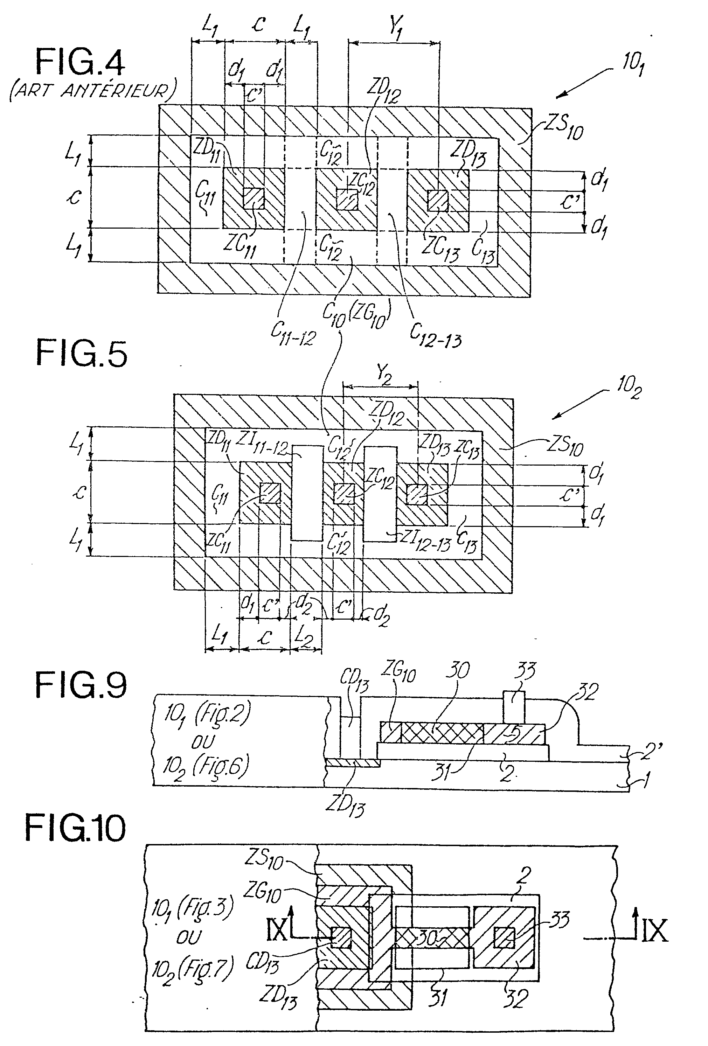

Comme on le voit sur les Figs. 9 et 10, la zone résistive 30 se trouve par exemple implantée à l'extrémité de la grille $ZG_{10}$, côté zone de drain extrême $ZD_{13}$, et au même niveau que $ZG_{10}$, c'est-à-dire sur zone isolante constituée par une couche d'oxyde de silicium épais 2. Ainsi, pour la fabrication d'une porte logique avec une telle zone résistive 30, la fenêtre $F_{20}$ n'est pas ouverte à l'étape b (Fig. 2), l'étape c est supprimée et, lors du quatrième masquage de l'étape d, une couche de silicium polycristallin est également déposée au niveau du site de la zone résistive 30, en quantité dépendant de la valeur ohmique désirée de la résistance 30. Afin de permettre l'ajustement de la résistance à une valeur élevée, de l'ordre de $25\,k\Omega$ par exemple, la zone d'implantation réelle de la résistance est déterminée par masquage de celle-ci pendant la diffusion des impuretés du type à conduction N de l'étape suivante e, qui est relative à l'implantation ionique des zones de source et de drain $ZS_{10}$, $ZD_{11}$, $ZD_{11}$ et $ZD_{13}$. Ce masquage est indiqué par le rectangle 31 sur la Fig. 10. La zone de grille $ZG_{10}$ ou, plus généralement, le reste de la surface du silicium polycristallin 5 n'étant pas masqué pendant l'étape e, la zone de grille $ZG_{10}$, non comprise la zone résistive 30, est fortement dopée et, par suite, présente une faible résistivé. Entre les étapes e et f, une étape intermédiaire est prévue pour doper faiblement la zone résistive 30 par diffusion d'impuretés du type à conduction N uniquement dans la zone 30, en vue d'ajuster convenablement la valeur ohmique élevée de la résistance de charge.

On a également représenté, aux Figs. 9 et 10, la zone de contact 32 de la résistance 30 qui est en silicium polycristallin fortement dopé et qui est reliée à la borne $V_{DD}$ à travers une zone de contact 33 en aluminium.

Une telle porte logique est utilisée avantageusement pour un fonctionnement à basse fréquence et à faible consommation. En effet, pour un tel fonctionnement, la mise en oeuvre d'un transistor de charge 20 implique une zone d'implantation de l'élément de charge relativement grande, puisque le courant de charge est proportionnel au rapport W/L, ce qui conduit à une longueur L du canal de transistor de charge très grande. Au contraire, lorsque l'élément de charge est une résistance 30 de valeur ohmique élevée, l'encombrement de celui-ci est réduit.

On notera que les deux mesures proposées dans le présent document peuvent être combinées à celles selon la demande de brevet français No. 2.411.512. Ces combinaisons sont indiquées aux Figs. 6 et 7 dans lesquelles le bloc de droite est un élément de charge tel qu'un transistor de charge 20 (Figs. 2 et 3) ou tel qu'une résistance 30 (Figs. 9 et 10), et aux Figs. 9 et 10 dans lesquelles le bloc de gauche est un transistor inverseur multidrain tel que $10_1$ (Figs. 2 et 3) ou tel que $10_2$ (Figs. 6 et 7). Ces différentes combinaisons sont choisies en fonction de l'utilisation de la porte logique qui dépend des caractéristiques principales telles que rapidité de commutation, densité d'intégration et consommation.

**Revendications**

1. Porte logique constituée par un transistor inverseur ($10_2$) multidrain à structure intégrée MOS monocanale du type à enrichissement et par un élément de charge (20; 30) ayant une zone de contact reliée à la zone de grille ($ZG_{10}$) du transistor inverseur, laquelle porte présente un premier niveau d'implantation sur la surface d'un substrat semi-conducteur d'un type de conductivité prédéterminée (1) dans lequel sont implantées la zone de source unique ($ZS_{10}$) et chaque zone de drain ($ZD_{11}-ZD_{13}$) du transistor inverseur du type de conductivité opposée, séparées par la zone de canal unique ($C_{10}$) du transistor inverseur ($10_2$), et un second niveau d'implantation constituant au moins la zone de grille ($ZG_{10}$) en silicium polycristallin (5) du transistor inverseur ($10_2$) qui est superposée à ladite zone de canal ($C_{10}$) par l'intermédiaire d'une couche isolante (3) au-dessus du premier niveau d'implantation et qui est entourée complètement par la zone de source ($ZS_{10}$), caractérisée en ce qu'au moins une zone de drain ($ZD_{11}$) est séparée d'une zone de drain voisine ($ZD_{12}$) par une zone isolante ($ZI_{11-12}$) s'étendant du premier niveau d'implantation jusqu'au moins au-delà du second niveau d'implantation.

2. Porte logique conforme à la revendication 1, caractérisée en ce que la distance ($d_2$) entre la zone de contact (CD) d'un drain (D) et une zone isolante voisine (ZI) est plus petite que la distance ($d_1$) entre ladite zone de contact (CD) du drain (D) et la zone de grille ($ZG_{10}$).

3. Porte logique conforme à l'une des revendications 1 et 2, caractérisée en ce que l'élément de charge est un transistor à structure intégrée MOS monocanale (20) ayant au moins la zone de contact (ZS$_{20}$) de sa zone de source (S$_{20}$) constituée par une partie extrême (4) de la zone de grille (ZG$_{10}$) du transistor inverseur (10$_2$).

4. Porte logique conforme à l'une des revendications 1 ou 2 caractérisée en ce que l'élément de charge est une zone résistive (30) implantée au-dessus du premier niveau d'implantation par l'intermédiaire d'une zone isolante (2).

5. Porte logique conforme à la revendication 4, caractérisée en ce que la zone résistive (30) est en silicium polycristallin (5).

6. Porte logique conforme à la revendication 4 ou 5, caractérisée en ce qu'une partie extrême de la zone de grille (ZG$_{10}$) du transistor inverseur (10$_1$; 10$_2$) constitue ladite zone résistive (30), qui est réalisée par masquage en même temps que la zone de grille (ZG$_{10}$).

7. Porte logique conforme à la revendication 4 ou 5, caractérisée en ce qu'au moins une partie du silicium polycristallin (5) constituant ladite zone résistive (30) est dopée plus faiblement que la zone de grille et est obtenue par masquage de ladite zone résistive (30; 31) lors de l'implantation des zones de source (ZS$_{10}$) et de drain (ZD$_{11}$—ZD$_{13}$) du transistor inverseur (10$_1$; 10$_2$), puis par diffusion d'impuretés du type de conduction opposée uniquemen· ans la zone résistive (30).

8. Porte logique conforme à l'une des revendications 4 à 7, caractérisée en ce que la zone de grille (ZG$_{10}$) du transistor inverseur (10$_1$) entoure complètement au moins une zone de drain (ZD) et est au-dessus de la zone de canal (C$_{10}$) par l'intermédiaire de la couche isolante (3).

## Patentansprüche

1. Torschaltung mit einem Umkehrtransistor (10$_2$) mit mehrfachen Drainen, als integrierte MOS-Einzelkanal-Aufbau für Anreichungsbetrieb und mit einem Lastelement (20, 30), das eine mit der Gate-Zone (ZG$_{10}$) des Umkehrtransistors verbundene Kontaktzone aufweist, und bei welcher sich auf der Oberfläche eines Halbleitersubstrates (1) mit vorgegebenem Leitfähigkeitstyp eine erste Implantationsebene befindet, in welcher die einzige Source-Zone (ZS$_{10}$) und jede Drain-Zone (ZD$_{11}$—ZD$_{13}$) des Umkehrtransistors mit entgegengesetztem Leitfähigkeitstyp durch die Zone des Einzelkanals (C$_{10}$) des Umkehrtransistors (10$_2$) voneinander getrennt implantiert sind; und mit einer zweiten Implantationsebene, die mindestens die Gate-Zone (ZG$_{10}$) aus polykristallinem Silicium des Umkehrtransistors (10$_2$) bildet, die unter Zwischenlage einer Isolierschicht (3) des Einzelkanalzone (C$_{10}$) überlagert oberhalb der ersten Implantationsebene angeordnet und von der Source-Zone (ZS$_{10}$) vollständig umgeben ist, dadurch gekennzeichnet, daß mindestens eine Drain-Zone (ZD$_{11}$) von einer benachbarten Drain-Zone (ZD$_{12}$) durch eine Isolierzone (ZI$_{11-12}$) getrennt ist, die sich aus der ersten Implantationsebene bis mindestens über die zweite Implantationsebene hinaus erstreckt.

2. Torschaltung nach Anspruch 1, dadurch gekennzeichnet, daß der Abstand (d$_2$) zwischen der Kontaktzone (CD) eines Drains (D) und einer benachbarten Isolierzone (ZI) kleiner ist als der Abstand (d$_1$) zwischen der Kontaktzone (CD) des Drains (D) und der Gate-Zone (ZG$_{10}$).

3. Torschaltung nach Anspruch 1 oder 2, dadurch gekennzeichnet, daß das Lastelement ein integrierter MOS-Einzelkanaltransistor (20) ist, bei welchem mindestens der Kontaktzone (ZS$_{20}$) seiner Source-Zone (S$_{20}$) durch einen Anschlußteil (4) der Gate-Zone (ZG$_{10}$) des Umkehrtransistors (10$_2$) gebildet ist.

4. Torschaltung nach Anspruch 1 oder 2, dadurch gekennzeichnet, daß das Lastelement eine Widerstandszone (30) ist, die unter Zwischenlage einer Isolierzone (2) oberhalb der ersten Implantationsebene implantiert ist.

5. Torschaltung nach Anspruch 4, dadurch gekennzeichnet, daß die Widerstandszone (30) aus polykristallinem Silicium (5) besteht.

6. Torschaltung nach Anspruch 5, dadurch gekennzeichnet, daß ein Anschlußteil der Gate-Zone (ZG$_{10}$) des Umkehrtransistors (10$_1$; 10$_2$) die Widerstandszone (30) bildet, die durch Maskierung gleichzeitig mit der Gate-Zone (ZG$_{10}$) hergestellt ist.

7. Torschaltung nach Anspruch 4 oder 5, dadurch gekennzeichnet, daß mindestens ein Teil des Polykristallinen Siliciums (5), das die Widerstandszone (30) bildet, schwächer dotiert ist als die Gate-Zone und durch Maskierung der Widerstandszone (30; 31) während der Implantation der Source-Zone (ZS$_{10}$) und der Drain-Zonen (ZD$_{11}$—ZD$_{13}$) des Umkehrtransistors (10; 10$_2$) und dann durch Diffusion Verunreinigungen vom entgegengesetzten Leitfähigkeitstyp allein in der Widerstandszone (30) erhalten worden ist.

8. Torschaltung nach einem der Ansprüche 4 bis 7, dadurch gekennzeichnet, daß die Gate-Zone (ZG$_{10}$) des Umkehrtransistors (10$_1$) mindestens eine Drain-Zone (ZD) vollständig umgibt und sich unter Zwischenlage einer Isolierschicht (3) oberhalb der Kanalzone (C$_{10}$) befindet.

## Claims

1. Logic gate constituted by an inverter multidrain transistor (10$_2$) having an integrated monochannel enhancement mode MOS structure and by a load element (20; 30) having a contact region connected to the gate region (ZG$_{10}$) of the inverter transistor, said gate including a first implantation plane on the surface of a semiconductor substrate of a predetermined conductivity type (1) in which are implanted the single source region (ZS$_{10}$) and each drain region (ZD$_{11}$—ZD$_{13}$) of the inverter transistor which are of the opposite conductivity type and are separated by the single channel region (C$_{10}$) of

the inverter transistor $(10_2)$, and a second implantation plane constituting at least the gate region $(ZG_{10})$ of the inverter transistor $(10_2)$ that is composed of polycrystalline silicon (5), that is superimposed over said channel region $(C_{10})$ through an insulating layer (3) above the first implantation plane and that is entirely surrounded by the source region $(ZS_{10})$, characterized in that at least a drain region $(ZD_{11})$ is separated from a neighbouring drain region $(ZD_{12})$ through an insulating zone $(ZI_{11-12})$ stretching from the first implantation plane to at least beyond the second implantation plane.

2. Logic gate according to claim 1, characterized in that the distance $(d_2)$ between the contact region (CD) of a drain (D) and a neighbouring insulation zone $(ZI_{11-12})$ is less than the distance $(d_1)$ between said contact region (CD) of the drain (D) and the gate region $(ZG_{10})$.

3. Logic gate according to claim 1 or 2, characterized in that the load element is a load transistor (20) having an integrated monochannel MOS structure and at least the contact region $(ZS_{20})$ of its source region $(S_{20})$ constituted by an end portion (4) of the gate region $(ZG_{10})$ of the inverter transistor $(10_2)$.

4. Logic gate according to claim 1 or 2, characterized in that the load element is a resistive region (30) implanted below the first implantation plane through an insulating zone (2).

5. Logic gate according to claim 4, characterized in that the resistive region (30) is composed of polycrystalline silicon (5).

6. Logic gate according to claim 4 or 5, characterized in that an end portion of the gate region $(ZG_{10})$ of the inverter transistor $(10_1; 10_2)$ forms said resistive region (30) which is obtained from masking simultaneously with said gate region $(ZG_{10})$.

7. Logic gate according to claim 4 or 5, characterized in that at least a portion of the polycrystalline silicon (5) constituting said resistive region (30) is doped more slightly than the gate region and is obtained from masking of said resistive region (30; 31) during the implantation of the source region $(ZS_{10})$ and drain regions $(ZD_{11}—ZD_{13})$ of the inverter transistor $(10_1; 10_2)$, then from diffusion of impurities of the opposite conductivity type only into the resistive region (30).

8. Logic gate according to any one of claims 4 to 7, characterized in that the gate region $(ZG_{10})$ of the inverter transistor $(10_1)$ entirely surrounds at least a drain region (ZD) and is over the channel region $(C_{10})$ through the insulating layer (3).

# FIG.1 (ART ANTÉRIEUR)

# FIG.8

# FIG.2 *(ART ANTÉRIEUR)*

# FIG.3 *(ART ANTÉRIEUR)*

# FIG.6

*20 (Fig.2)*
*OU*
*30 (Fig. 9)*

# FIG.7

*20 (Fig.3)*
*OU*
*30 (Fig.10)*